# EUROPÄISCHE PATENTSCHRIFT

(11) **EP 1 834 008 B1**
(45) Veröffentlichungstag und Bekanntmachung des Hinweises auf die Patenterteilung: **29.07.2009**
(21) Anmeldenummer: 05846522.0
(22) Anmeldetag: 25.11.2005
(51) Int. Cl.: C23C 16/30, C23C 30/00, B32B 27/14, C23C 28/00, C23C 16/36, C23C 16/40, C23C 16/34

(54) **AL2O3-MULTILAGENPLATTE**
AL2O3 MULTILAYER PLATE
PLAQUE MULTICOUCHE D'AL2O3

(30) Priorität: 30.12.2004 DE 102004063816
(43) Veröffentlichungstag der Anmeldung: 19.09.2007
(73) Patentinhaber: WALTER Aktiengesellschaft, 72072 Tübingen (DE)
(72) Erfinder: HOLZSCHUH, Helga, 72537 Mehrstetten (DE)
(74) Vertreter: Rüger, Barthelt & Abel Patentanwälte
(86) Internationale Anmeldenummer: PCT/EP2005/012611
(87) Internationale Veröffentlichungsnummer: WO 2006/072288

(56) Entgegenhaltungen:
- EP-A- 0 727 509
- EP-A- 0 727 510
- EP-A- 0 753 603
- EP-A- 1 245 700
- EP-A- 1 247 789
- EP-A- 1 348 779
- EP-A- 1 455 003
- DE-A1- 10 123 554
- US-A- 4 746 563
- US-A- 5 700 569
- US-B1- 6 221 479
- US-B1- 6 333 099

## Beschreibung

Die Erfindung betrifft eine Schneidplatte mit verschleißmindernder Beschichtung oder ein Schneidwerkzeug mit einer solchen verschleißmindernden Beschichtung.

An Schneidwerkzeuge werden heute erhebliche Anforderungen hinsichtlich der Standfestigkeit und der Belastbarkeit gestellt. Diese Anforderungen ergeben sich bei der Zerspanung besonders harter oder zäher Materialien wie wegen der angestrebten Erhöhung der Schnittgeschwindigkeit. Als verschleißmindernde Beschichtung haben sich insbesondere zur Stahlzerspanung Aluminiumoxidschichten etabliert. Allerdings stellt sich dabei mehr und mehr heraus, dass die Belastbarkeit der Schneidplatten und deren Standfestigkeit gegen verschiedene Verschleißarten nicht nur von der stofflichen Beschaffenheit der verwendeten, verschleißmindernden Beschichtungen sondern auch von der Schichtfolge und insbesondere auch den verwendeten Schichtdicken und deren Haftung bzw. der Haftung der Einzellagen abhängt. Die US-A-4 746 563 bezieht sich auf Schneidwerkzeuge, die eine Multilagenschicht aufweisen, dessen Zweck zur Verbesserung des Verschleisswiederstandes des Schneidwerkzeug ist.

Dazu ist es aus der EP 1 348 779 A1 beispielsweise bekannt, eine verschleißmindernde Beschichtung vorzusehen, die eine Aluminiumoxidschicht enthält, die zwischen TiCN-Schichten eingebettet ist. Während die Dicke des gesamten Aufbaus 30 µm nicht überschreitet, wird des Weiteren festgelegt, dass die Aluminiumoxidschicht ein bis drei mal so dick sein soll wie die darunter liegende TiCN-Schicht und dass die außen liegende TiCN-Schicht 0,1 bis 1,2 mal so dick sein soll wie die beiden darunter liegenden Schichten zusammen genommen.

Mit diesem Schichtaufbau sollen sich gute Zerspanungsergebnisse erzielen lassen.

Die US 6 221 479 B1 versucht, die Schneideigenschaften von Schneidplatten durch Einflussnahme auf die Beschaffenheit des Grundkörpers zu verbessern.

Hingegen schlägt die DE 101 23 554 A1 ein Verfahren zur Erhöhung der Druckspannungen oder zur Erniedrigung der Zugeigenspannungen in einer äußeren Schicht einer verschleißmindernden Beschichtung vor. Diese wird einer Strahlbehandlung unterzogen, im Rahmen derer beispielsweise ein Zirkonoxidkeramikgranulat, druckverdüstes Stahlpulver oder ein gesintertes Hartmetallsprühgranulat gegen die zu behandelnde Oberfläche trockengestrahlt wird. Die Maßnahme führt zu einer Oberflächenglättung und Verminderung von Zugeigenspannungen oder Erzeugung von Druckeigenspannungen in der Beschichtung.

Aus der EP 0 727 509 B1 ist eine Schneidplatte mit einer Multilagen κ-Al₂O₃-Schicht bekannt, die sechs bis acht Al₂O₃-Lagen aufweist. Unter den κ-Al₂O₃-Lagen ist als sogenannte Zwischenlage eine TiC-, TiN- oder TiCN-Lage angeordnet. Zwischen den κ-Al₂O₃-Lagen ist zur Verbesserung der Anbindung der x-Al₂O₃-Lagen an die jeweils darunter liegende κ-Al₂O₃-Lage jeweils eine Modifikationsschicht ausgebildet, die eine (Alₓ-Tiy) (O_{w}C_{z}Nᵤ) -Schicht mit x und y = 2 . . . 4 ist. Die κ-Al₂O₃-Multilagenschicht ist auf eine Grundschicht, z.B. aus TiCN, aufgebracht.

Davon ausgehend ist es Aufgabe der Erfindung, eine entsprechende Schneidplatte bzw. ein Schneidwerkzeug weiter zu verbessern.

Diese Aufgabe wird mit der Schneidplatte oder dem Schneidwerkzeug nach Anspruch 1 gelöst:

Die erfindungsgemäße Schneidplatte bzw. das Schneidwerkzeug weist eine verschleißmindernde Beschichtung auf, die zuunterst eine erste ein- oder mehrlagige Schicht bestehend aus mindestens einer Schicht aus Nitriden, Carbiden, Carbonitriden oder Oxicarbonitrieden, Boronitriden, Borocarbonitriden, Borocarbooxinitriden von Metallen der 4. oder 5. oder 6. Nebengruppe oder einer Kombination dieser Verbindungen aufweist. Darauf ist eine zweite Schicht aus Al₂O₃-Multilagen aufgebracht. Auf dieser ist eine Deckschicht vorgesehen, die aus Nitriden, Carbiden, Carbooxonitriden oder Carbonitriden von Ti, Zr oder Hf oder einer Kombination dieser Schichten besteht und deren Dicke vorzugsweise größer als 3 µm ist. Diese Kombination hat sich als zerspanungstechnisch überlegen herausgestellt. Dies gilt insbesondere bei der Stahlzerspanung und bei unterbrochenem Schnitt. Während die Al₂O₃-Schicht per se wärmeisolierend ist und den Kolkverschleiß mindert, ist der Aufbau als Multilagenschicht insbesondere wegen der damit einhergehenden Verminderung der inneren Spannungen vorteilhaft. Dies wirkt sich beim unterbrochenen Schnitt vorteilhaft aus. Die großzügig bemessene Deckschicht, die aus wenigstens zwei Schichten der Gruppe Nitride, Carbide, Carbooxonitride oder Carbonitride von Ti, Zr oder Hf oder einer Kombination dieser Schichten besteht, erbringt zugleich eine hohe abrasive Verschleißfestigkeit. Die Deckschicht ist vorzugsweise eine MT-TiCN-Schicht und ist dabei wesentlich dicker als jede darunter liegende Al₂O₃-Schicht. Sie ist vorzugsweise um den Faktor 1,5 bis 2 dicker als die einzelne Al₂O₃-Lage.

Die einzelnen Al₂O₃-Lagen weisen eine Dicke von 0,5 µm bis 4 µm, vorzugsweise 2 µm auf. Sie sind im CVD-Verfahren aufgebracht. Die Zwischenlagen sind vorzugsweise kombinierte TiCN-TiCNO-Lagen, wobei zur Verbesserung der Anbindung zwischen den TiCN-TiCNO-Lagen und den Al₂O₃-Lagen TiAlCNO-Zwischenverankerungsschichten vorgesehen sein können. Diese weisen vorzugsweise eine Phasenmischung aus TiCN und Al₂TiO₅ (Pseudo-Brookit-Struktur) auf. Die besonders gute Anbindung wird erreicht, indem der Aluminiumgehalt höchstens auf 4 at% festgesetzt wird. Dabei hat sich herausgestellt, dass insbesondere die Schichtfolge Al₂O₃-TiCN-TiCNO-TiAICNO-Al₂O₃ zweckmäßig ist. Auf die Al₂O₃-Schicht kann unmittelbar eine TiCN-Schicht aufgebracht werden. Hier ist keine Zwischenverankerungsschicht erforderlich.

Mit dem speziellen Zwischenschichtaufbau werden insbesondere unter Nutzung einer TiCN-Lage insgesamt eine sehr geringe Schichteigenspannung und niedriger Verschleiß bei unterbrochenem Schnitt und hohe Abrasionsfestigkeit erreicht. Z.B. weist die TiCN-Zwischenlage eine Schichteigenspannung von lediglich 100 bis 150 MPa auf. Dies ist eine wesentliche Verbesserung bspw. gegenüber TiN-Zwischenlagen, die eine Schichteigenspannung von 200 bis 300 MPa aufweisen, und gestattet insgesamt die Senkung der Schichteigenspannung der gesamten Multilagenschicht. Durch den gegebenenfalls auch gleitenden Übergang zu oxidativen Schichten (TiCNO) und evtl. zusätzlich aluminiumhaltigen Schichten (TiAlCNO) wird zusätzlich die Haftung der Al₂O₃-Schichten in dem Multilagenaufbau wesentlich verbessert.

Die Zwischenlagen haben vorzugsweise eine Schichtdicke zwischen 0,2 µm und 2 µm. Vorzugsweise beträgt die Dicke 1,0 µm. Die Zwischenverankerungsschichten weisen eine Dicke von 0,1 µm bis 0,7 µm, vorzugsweise 0,5 µm auf.

Die derart aufgebaute Al₂O₃-Multilagenschicht gibt der Schneidplatte insbesondere in Verbindung mit der Deckschicht von mehr als 3 µm sehr gute Verschleißeigenschaften.

Die Al₂O₃-Multilagenschicht ist vorzugsweise auf eine Grundschicht (TiCN-Schicht) aufgebracht. Zur Verbindung können wiederum eine TiCNO-Schicht und eine TiAlCNO-Verankerungsschicht dienen, deren Aluminiumgehalt vorzugsweise unter 4 at% liegt. Die Verankerungsschicht weist eine Dicke von z.B. lediglich 0,5 µm auf. Vorzugsweise weist die Grundschicht dann einen Mehrlagenaufbau mit folgendem Aufbau von außen nach innen auf:
6) HT - TiAICNO
5) HT - TiCNO
4) HT - Ti(CₓN_{y})₁ (kohlenstoffreich), x > 0,5
3) HT - Ti(CₓN_{y})₁ (stickstoffreich), y > 0,5
2) MT - TiCN
1) MT - TiN

Dabei steht "HT" für einen Hochtemperatur-CVD-Prozess (über 950°C Prozesstemperatur) und "MT" für einen Mitteltemperatur-CVD-Prozess (unter 950°C Prozesstemperatur).

Dieser gesamte Schichtaufbau lässt sich im CVD-Verfahren herstellen. Das besondere an diesem Schichtaufbau ist die Tatsache, dass sich die Eigenspannungen der Zwischenlagen sowie der Al₂O₃- und der Deckschichtlage nach der ersten Al₂O₃-Schicht wesentlich erniedrigen. Dies erklärt die geringeren aufsummierten Eigenspannungen dieser Multilagenschichten. Die Eigenspannungen sind dabei in der Regel positiv, d.h. es handelt sich um Zugspannungen. Bei einer besonders bevorzugten Ausführungsform werden diese zumindest in der Nähe der Oberfläche in Druckspannungen umgewandelt. Dazu wird auf die außen liegende TiCN-Schicht noch eine weitere Schicht, beispielsweise eine TiN-Außenschicht aufgebracht, die wenigstens abschnittsweise wieder entfernt wird. Das Abtragen dieser Schicht kann mit einem abrasiven Verfahren, beispielsweise einem Nassstrahlverfahren erfolgen. Dabei ergeben sich in der Deckschicht zumindest im äußeren Bereich derselben hohe Druckspannungen und eine Erhöhung der Härte an der Randzone, die die Rissanfälligkeit, insbesondere Kammrissempfindlichkeit, der Schicht extrem vermindern.

Neben der Lagenabhängigkeit der Eigenspannungen zeigen auch die Schichten abhängig von ihrer Position im Gesamtsystem des Schichtaufbaus unterschiedliche Vorzugsorientierungen.

Weitere vorteilhafte Einzelheiten von Ausführungsformen der Erfindung ergeben sich aus der Zeichnung oder der Beschreibung. In der Zeichnung ist ein Ausführungsbeispiel der Erfindung veranschaulicht. Es zeigen:
- Figur 1: den Schichtaufbau einer erfindungsgemäßen Beschichtung einer verbesserten Schneidplatte in schematischer Darstellung und
- Figur 2: Spannungen in dem äußeren Schichtaufbau (letzte Al₂O₃-Schicht und Deckschicht) vor und nach dem Abtrag einer außen liegenden TiN-Schicht.

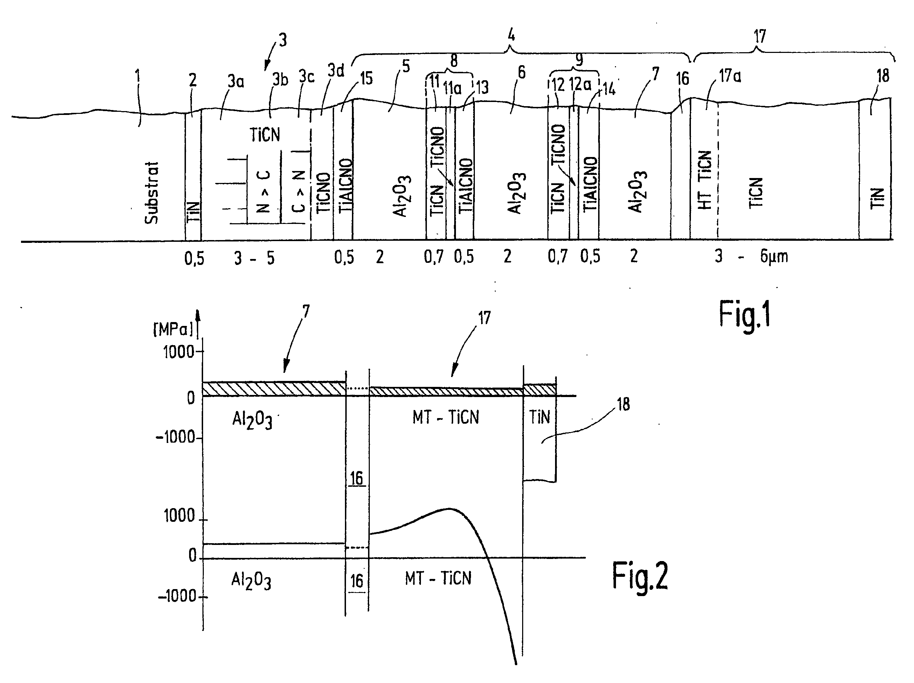

In Figur 1 ist der Schichtaufbau einer erfindungsgemäßen Schneidplatte oder eines Schneidwerkzeugs veranschaulicht. Sie weist einen Grundkörper 1 auf, der in Figur 1 als Substrat gekennzeichnet ist. Auf dieses ist im CVD-Verfahren eine Grundschicht 2, bestehend aus TiN, aufgebracht. Die Schicht weist eine Dicke von ungefähr 1 µm, vorzugsweise weniger - z.B. 0,5 µm, auf. Auf diese Grundschicht 2 folgt eine erste Schicht 3, bestehend aus mehreren TiCN-Teilschichten 3a, 3b, 3c (genaugenommen Ti(CₓN_{y})₁-Teilschichten) und einer TiCNO-Schicht 3d. Die erste Teilschicht 3a ist bei relativ moderaten Temperaturen aufgebracht, die z.B. unterhalb 950°C liegen. Die Teilschicht 3a wird deshalb auch als MT-TiCN-Schicht bezeichnet und hat eine kolumnare Struktur. Darauf folgt die bei höherer Temperatur erzeugte stickstoffreiche polykristalline TiCN-Teilschicht 3b (Ti(CₓN_{y})₁, y>0,5). Diese kann als Diffusionssperre wirken. Darauf folgt die weitere, ebenfalls bei höherer Temperatur aufgebrachte, kohlenstoffreiche TiCN-Teilschicht 3c (Ti(CₓN_{y})₁, x>0,5) mit zum Teil nadelförmiger Kristallstruktur. Auf die TiCNO-Schicht 3d mit ebenfalls nadelförmiger Struktur können noch weitere Schichten aufgebracht werden, z.B. eine TiAlCNO-Schicht 15 zur besseren Anbindung nachfolgender Al₂O₃-Schichten. Diese kann eine Dicke von 0,2 µm bis 1,0 µm aufweiseh. Die erste Schicht 3 weist insgesamt eine columnare Struktur auf, wobei die einzelnen Säulen durchschnittlich eine Breite von 0,1 bis 0,3 µm (vermessen bei einem Beschichtungsversuch bei 10 µm Schichtdicke) aufweisen. Die Schicht ist somit feinsäulig aufgebaut. Die Säulen sind senkrecht zu den einzelnen Schichten, d.h. in Figur 1 horizontal, orientiert. Die Schicht 15 hat eine Nadel- oder Blättchenstruktur zur besseren mechanischen Anbindung der Al₂O₃-Schicht. Der oben genannte komplizierte Schichtaufbau wirkt der Diffusion von Stoffen aus dem Hartmetall in die Schichten entgegen und verbessert die Schichtanbindung der verschleißmindernden Beschichtung.

Auf die TiCN-Schicht ist eine Al₂O₃-Multilagenschicht 4 aufgebracht, deren Gesamtdicke vorzugsweise zwischen 8 µm und 10 µm liegt. Sie weist wenigstens zwei, vorzugsweise aber mehrere (vorzugsweise nicht mehr als fünf) Einzellagen auf. Zu diesen gehören Al₂O₃-Lagen 5, 6, 7, die jeweils eine Dicke von etwa 2 µm aufweisen. Die Al₂O₃-Lagen sind z.B. κ-Al₂O₃-Lagen. Dies führt zu einer relativ guten Wärmeisolation durch die Al₂O₃-Lagen und einer guten thermischen Belastbarkeit, was bei der Stahlbearbeitung Vorteile bringt. Die Al₂O₃-Lagen können aber auch α-Al₂O₃-Lagen sein. Diese haben eine höhere Wärmeleitfähigkeit und sind auch bei hohen Temperaturen stabil. Sie können zu besseren Ergebnissen bei der Gusseisenzerspanung führen. Es wird außerdem vorgesehen α-Al₂O₃-Lagen mit κ-Al₂O₃-Lagen zu kombinieren. Z.B. können sich jeweils ein oder mehrere α-Al₂O₃-Lagen mit ein oder mehreren κ-Al₂O₃-Lagen abwechseln. Es ist auch möglich, auf eine oder mehrere α-Al₂O₃-Lagen ein oder mehrere κ-Al₂O₃-Lagen aufzubringen. Damit bilden die κ-Al₂O₃-Lagen eine thermische Barriere, die die α-Al₂O₃-Lagen thermisch schützt.

Zwischen den Al₂O₃-Lagen 5, 6, 7 sind Zwischenlagen 8, 9 ausgebildet. Sie bestehen jeweils zumindest aus einer TiCN-Lage 11, 12 und einer TiCNO-Lage 11a, 12a. Außerdem können sie eine TiAlCNO-Lage 13, 14 enthalten. Die Gesamtdicke der Zwischenlagen 8, 9 liegt vorzugsweise zwischen 0,5 und 1,5 µm. Beispielsweise sind die TiCN-Lagen 11, 12 in Verbindung mit den TiCNO-Lagen 11a, 12a jeweils etwa 0,7 µm dick während die darauf ausgebildete TiAlCNO-Zwischenverankerungsschicht 13, 14 jeweils eine Dicke von 0,5 µm aufweist. Die Zwischenverankerungsschicht 13, 14 dient in Verbindung mit der darunter liegenden TiCNO-Lage 11a, 12a dazu, die Al₂O₃-Lage 6, 7 jeweils fest an die darunter liegende TiCN-Lage 11, 12 anzubinden. Zwischen der Al₂O₃-Lage 5 und der ersten Schicht 3 kann ebenfalls eine TiAlCNO-Schicht von 0,5 µm Dicke vorgesehen sein, die eine Verankerungsschicht 15 bildet.

Die gesamte Al₂O₃-Multilagenschicht ist im CVD-Verfahren abgeschieden. Aufgrund des Multilagenaufbaus mit niedrigeren Eigenspannungen ergeben sich insgesamt dabei geringe Schichteigenspannungen.

Auf die Al₂O₃-Multilagenschicht 4 ist gegebenenfalls vermittels einer geeigneten Anbindungsschicht 16 (z.B. TiCNO oder TiAlCNO) eine Deckschicht 17 aufgebracht. Die Deckschicht 17 besteht aus unterschiedlichen TiCN-Schichten mit unterschiedlichem C/N-Verhältnis und Mikrostruktur und einer TiN Schicht. Die TiCN-Schichten bestehen zum größten Teil auseiner MT-Schicht und weisen insgesamt eine Dicke von 3 µm bis 6 µm auf. Sie weist eine kolumnare Struktur mit rechtwinklig zu der Schichtebene orientierten Säulen auf. Die Säulen sind relativ breit. Es wird für die Säulenbreiten ein Bereich von 0,4 bis 0,5 µm in 6 µm Dicke bevorzugt. Unter der MT-TiCN-Schicht ist eine HT-TiCN-Schicht 17a vorgesehen. Es ergeben sich insgesamt die in Figur 2 oben veranschaulichten Schichteigenspannungen. Sowohl die Al₂O₃-Schicht 7 als auch die MT-TiCN-Schicht 17 stehen unter geringen Zugspannungen.

Obwohl die Schneidplatte in dieser Konfiguration schon beste Zerspanungsleistungen, insbesondere beim Zerspanen von Gusseisen und Stahl im unterbrochenen Schnitt zeigt, lässt sich die Leistungsfähigkeit der Schneidplatte noch verbessern, indem die TiN-Schicht 18 aufgebracht und dann mittels einer Nachbehandlung wieder ganz oder teilweise (insbesondere mechanisch) entfernt wird. Der sich daraus ergebende Spannungsverlauf ist in Figur 2 unten veranschaulicht. Die MT-TiCN-Schicht baut in ihrem äußeren Bereich hohe Druckspannungen auf. Diese Druckspannungen können, abhängig von dem mechanischen Bearbeitungsvorgang, zur Schichtabtragung bis in die Al₂O₃-Schichten reichen. Bei der bevorzugten Ausführungsform bleiben die Druckspannungen innerhalb der MT-TiCN-Schicht. Die eingebrachten Druckspannungen neutralisieren sich vorzugsweise innerhalb der TiCN-Schicht , d.h. sie weist außen hohe Druckspannungen und innen leicht erhöhte Zugspannungen auf.

Durch lediglich lokales Entfernen der TiN-Schicht 18, z.B. an der Spanfläche der Schneidplatte, können zweifarbige Schneidplatten erzeugt werden. Die TiN-Schicht weicht farblich von der TiCN-Schicht ab.

Im Ausführungsbeispiel können sich folgende Zugspannungen ergeben:

| | |
|---|---|
| Erste MT-Schicht, Schicht (3) : | +612 MPa |
| Zweite MT-Schicht, Deckschicht (17) : | +202 MPa |
| Erste Al₂O₃-Lage (5) : | +667 MPa |
| HT-TiCN-Zwischenlagen : | +100 ... 150 MPa |
| Dritte Al₂O₃-Lage (7) : | +343 MPa |

Mit dem dargestellten Schichtaufbau kann die Multilagen-Al₂O₃-Schicht mit geringer Zugeigenspannung (von z.B. lediglich ≈200 MPa) erzeugt werden. Niedrigere Eigenspannungen werden hinsichtlich der Zerspanungseigenschaften hier als förderlich angesehen. Auch weisen weiter außen liegende Al₂O₃-Schichten 6, 7 niedrigere Eigenspannungen auf als die Grundschicht 3 oder die innere Al₂O₃-Schicht 5. Dies führt zu einem spannungsmäßig vorteilhaften Zustand des Gesamtaufbaus mit niedrigen Eigenspannungen sowohl in der Deckschicht als auch in der Multilagen- Al₂O₃-Schicht.

Zur Durchführung eines Zerspanungstests wurden herkömmliche Schneidplatte mit einlagiger Al₂O₃-Beschichtung und dicker TiCN-Deckschicht sowie auch Schneidplatten mit einlagiger Al₂O₃-Schicht und dünner TiN-Deckschicht mit einer erfindungsgemäßen Schneidplatte des hier beschriebenen Aufbaus verglichen. Es ergab sich im Vergleich zu den herkömmlichen Platten sowie auch im Vergleich zu einer Platte mit einer einlagigen Aluminiumoxidschicht mit TiCN-Deckschicht eine erhebliche Standzeiterhöhung bei Stahlzerspanung im glatten oder gleichbleibenden Schnitt. Noch deutlicher zeigte sich die Verbesserung des Eigenspannungszustandes der erfindungsgemäßen Schneidplatte im unterbrochenem Schnitt (Leistendrehtest) in einer Reduzierung der Streuung der Standzeitergebnisse.

Der Schichtaufbau einer im CVD-Verfahren hergestellten Schneidplatte enthält eine dicke außen liegende Deckschicht 17 aus MT-TiCN und eine darunter liegende Multilayer-Al₂O₃-Schicht und eine erste Schicht aus TiN und MT-TiCN. Die Multilayer-Al₂O₃-Schicht besteht aus zwei, drei oder mehreren Aluminiumoxidschichten, zwischen denen TiCN-Schichten und gegebenenfalls zur Haftungsverbesserung TiCNO und TiAlCNO-Schichten angeordnet sind. Ein solcher Gesamtaufbau weist besonders gute Zerspanungseigenschaften auf.

## Patentansprüche

1. Schneidplatte für ein Schneidwerkzeug oder Schneidwerkzeug, mit einer verschleißmindernden Beschichtung aus:
einer mehrlagigen Grundschicht (2, 3), bestehend aus mindestens Nitriden, Carbiden, Carbonitriden und mindestens einem Oxicarbonitrid, Boronitrid, Borocarbonitrid, Borocarbooxinitrid oder einem Aluminiumhaltigen Oxicarbonitrid von Metallen der 4. und/oder 5. und/oder 6. Nebengruppe oder einer Kombinationen dieser Verbindungen,
einer Al₂O₃-Multilagenschicht (4), bestehend aus Al₂O₃-Lagen (5, 6, 7) und Zwischenlagen (8, 9), die jeweils wenigstens eine TiCN-Lage (11, 12) und jeweils wenigstens eine TiCNO-Lage (11a, 12a) enthalten und die zwischen den Al₂O₃-Lagen (5, 6, 7) angeordnet sind, und aus
einer wenigstens zweilagige Deckschicht (17) bestehend aus Nitriden, Carbiden, Carbooxonitriden oder Carbonitriden von Ti, Zr oder Hf oder einer Kombination dieser Schichten, deren Dicke größer als 3 µm ist.

2. Schneidplatte oder Schneidwerkzeug nach Anspruch 1, **dadurch gekennzeichnet, dass** die Al₂O₃-Lagen (5, 6, 7) eine Dicke von 0,5 µm bis 4 µm, vorzugsweise 1 µm bis 3 µm aufweisen.

3. Schneidplatte oder Schneidwerkzeug nach Anspruch 1, **dadurch gekennzeichnet, dass** die Deckschicht (17) 1,5 bis 2 mal so dick ist wie eine Al₂O₃-Lage (5, 6, 7).

4. Schneidplatte oder Schneidwerkzeug nach Anspruch 1, **dadurch gekennzeichnet, dass** die Al₂O₃-Lagen (5, 6, 7) eine Dicke von 2 µm aufweisen.

5. Schneidplatte oder Schneidwerkzeug nach Anspruch 1, **dadurch gekennzeichnet, dass** die TiCN-Lagen (11, 12) der Zwischenlagen (8, 9) polykristalline Schichten sind.

6. Schneidplatte oder Schneidwerkzeug nach Anspruch 1, **dadurch gekennzeichnet, dass** die Zwischenlagen (8, 9) zusätzlich zu der wenigstens einen TiCN-Lage (11, 12) und der wenigstens einen TiCNO-Lage (11a, 12a) wenigstens eine TiAlCNO-Zwischenverankerungsschicht (13, 14) aufweisen, die höchstens 4 at% Aluminium enthält.

7. Schneidplatte oder Schneidwerkzeug nach Anspruch 1, **dadurch gekennzeichnet, dass** die Zwischenlage (8, 9) eine Schichtdicke von 0,2 µm bis 2 µm, vorzugsweise 0,5 µm bis 1,5 µm aufweist.

8. Schneidplatte oder Schneidwerkzeug nach Anspruch 1, **dadurch gekennzeichnet, dass** die Zwischenlage (8, 9) eine Schichtdicke von 1 µm aufweist.

9. Schneidplatte oder Schneidwerkzeug nach Anspruch 6, **dadurch gekennzeichnet, dass** die TiAlCNO-Zwischenverankerungsschicht (13, 14) eine Dicke von 0,1 bis 0,7 µm aufweist.

10. Schneidplatte oder Schneidwerkzeug nach Anspruch 1, **dadurch gekennzeichnet, dass** die Al₂O₃-Multilagenschicht (4) auf eine TiAlCNO-Verankerungsschicht (15) mit höchstens 4 at% Aluminium aufgebracht ist.

11. Schneidplatte oder Schneidwerkzeug nach Anspruch 10, **dadurch gekennzeichnet, dass** die TiAlCNO-Verankerungsschicht (15) eine Dicke von 0,2 µm bis 1,0 µm aufweist.

12. Schneidplatte oder Schneidwerkzeug nach Anspruch 11, **dadurch gekennzeichnet, dass** die TiAlCNO-Verankerungsschicht (15) eine Dicke von 0,5 µm aufweist.

13. Schneidplatte oder Schneidwerkzeug nach Anspruch.1, **dadurch gekennzeichnet, dass** unter der TiAlCNO-Verankerungsschicht (15) die Grundschicht (3) teilweise als feinkolumnare MT-TiCN-Lage (3) mit einer Säulenbreite von 0,1 µm bis 0,5 µm ausgebildet ist.

14. Schneidplatte oder Schneidwerkzeug nach Anspruch 1, **dadurch gekennzeichnet, dass** die Grundschicht (3) von dem Substrat zu der Al₂O₃-Multilagenschicht (4) hin den folgenden Aufbau aufweist:
1) MT - TiN - Schicht (2)
2) MT - TiCN - Schicht (3a)
3) HT - Ti(CₓN_{y}) - Schicht (3b) (stickstoffreich), y>0,5
4) HT - Ti(CₓN_{y}) - Schicht (3c) (kohlenstoffreich), x>0,5
5) HT - TiCNO- Schicht (3d)
6) HT - TiAlCNO

15. Schneidplatte oder Schneidwerkzeug nach Anspruch 1, **dadurch gekennzeichnet, dass** die Deckschicht (17) eine Dicke von mindestens 5 µm aufweist

16. Schneidplatte oder Schneidwerkzeug nach Anspruch 1, **dadurch gekennzeichnet, dass** die Deckschicht (17) eine kolumnare Struktur mit einer Säulenbreite von 0,4 - 0,5 µm aufweist.

17. Schneidplatte oder Schneidwerkzeug nach Anspruch 1, **dadurch gekennzeichnet, dass** der gesamte Schichtaufbau im CVD-Verfahren erzeugt ist.

18. Schneidplatte oder Schneidwerkzeug nach Anspruch 1, **dadurch gekennzeichnet, dass** die Deckschicht (17) in einer äußeren Zone Druckspannungen aufweist.

19. Schneidplatte oder Schneidwerkzeug nach Anspruch 1, **dadurch gekennzeichnet, dass** die Deckschicht (17) wenigstens abschnittsweise mit einer Außenschicht (18) versehen ist und dass die Deckschicht (17) Zonen aufweist, in denen die Außenschicht nachträglich durch ein abrasives Verfahren entfernt worden ist.

20. Schneidplatte oder Schneidwerkzeug nach Anspruch 1, **dadurch gekennzeichnet, dass** zumindest eine der Al₂O₃-Lagen eine κ-Al₂O₃-Lage ist.

21. Schneidplatte oder Schneidwerkzeug nach Anspruch 1, **dadurch gekennzeichnet, dass** zumindest eine der Al₂O₃-Lagen eine α-Al₂O₃-Lage ist.

22. Schneidplatte oder Schneidwerkzeug nach Anspruch 1, **dadurch gekennzeichnet, dass** die Deckschicht (17) eine Zugeigenspannung aufweist, die um wenigstens 50% niedriger ist als die Zugeigenspannung der Grundschicht (3).

23. Schneidplatte oder Schneidwerkzeug nach Anspruch 1, **dadurch gekennzeichnet, dass** die äußere Al₂O₃-Schicht (7) eine Zugeigenspannung aufweist, die um mindestens 1/3 geringer ist als die Zugeigenspannung der inneren Al₂O₃-Schicht.

## Claims

1. Cutting tip for a cutting tool or cutting tool with a wear-reducing coating comprising:
a multilayered base layer (2, 3) composed at least of nitrides, carbides, carbonitrides and at least one oxycarbonitride, boron nitride, borocarbonitride, borocarbooxynitride or an oxycarbonitride containing aluminium or an oxycarbonitride containing aluminium of metals of the fourth and/or fifth and/or sixth sub-group or a combination of these compounds,
an Al₂O₃ multilayered layer (4) comprising Al₂O₃ layers (5, 6, 7) and intermediate layers (8, 9), which respectively contain at least one TiCN layer (11, 12) and respectively at least one TiCNO layer (11a, 12a) and which are arranged between the Al₂O₃ layers (5, 6, 7), and comprising
an at least two-layered cover layer (17) composed of nitrides, carbides, carbooxonitrides or carbonitrides of Ti, Zr or Hf or a combination of these layers, the thickness of which is greater than 3 µm.

2. Cutting tip or cutting tool according to claim 1, **characterised in that** the Al₂O₃ layers (5, 6, 7) have a thickness of 0.5 µm to 4 µm, preferably 1 µm to 3 µm.

3. Cutting tip or cutting tool according to claim 1, **characterised in that** the cover layer (17) is 1.5-times to twice the thickness of an Al₂O₃ layer (5, 6, 7).

4. Cutting tip or cutting tool according to claim 1, **characterised in that** the Al₂O₃ layers (5, 6, 7) have a thickness of 2 µm.

5. Cutting tip or cutting tool according to claim 1, **characterised in that** the TiCN layers (11, 12) of the intermediate layers (8, 9) are polycrystalline layers.

6. Cutting tip or cutting tool according to claim 1, **characterised in that** in addition to the at least one TiCN layer (11, 12) and the at least one TiCNO layer (11a, 12a) the intermediate layers (8, 9) have at least one TiAlCNO intermediate anchoring layer (13, 14), which contains 4 atom% aluminium at maximum.

7. Cutting tip or cutting tool according to claim 1, **characterised in that** the intermediate layer (8, 9) has a layer thickness of 0.2 µm to 2 µm, preferably 0.5 µm to 1.5 µm.

8. Cutting tip or cutting tool according to claim 1, **characterised in that** the intermediate layer (8, 9) has a layer thickness of 1 µm.

9. Cutting tip or cutting tool according to claim 1, **characterised in that** the TiAlCNO intermediate anchoring layer (13, 14) has a thickness of 0.1 to 0.7 µm.

10. Cutting tip or cutting tool according to claim 1, **characterised in that** the Al₂O₃ multilayered layer (4) is applied to a TiAlCNO anchoring layer (15) with 4 atom% aluminium at maximum.

11. Cutting tip or cutting tool according to claim 10, **characterised in that** the TiAlCNO anchoring layer (15) has a thickness of 0.2 µm to 1.0 µm.

12. Cutting tip or cutting tool according to claim 11, **characterised in that** the TiAlCNO anchoring layer (15) has a thickness of 0.5 µm.

13. Cutting tip or cutting tool according to claim 1, **characterised in that** under the TiAlCNO anchoring layer (15) the base layer (3) is partially configured as a fine-columnar MT-TiCN layer (3) with a column width of 0.1 µm to 0.5 µm.

14. Cutting tip or cutting tool according to claim 1, **characterised in that** the base layer (3) has the following structure from the substrate to the Al₂O₃ multilayered layer (4):
1) MT-TiN layer (2)
2) MT-TiCN layer (3a)
3) HT - Ti(CₓN_{y}) layer (3b) (rich in nitrogen), y > 0.5
4) HT - Ti(CₓN_{y}) layer (3c) (rich in carbon), x > 0.5
5) HT - TiCNO layer (3d)
6) HT - TiAlCNO.

15. Cutting tip or cutting tool according to claim 1, **characterised in that** the cover layer (17) has a thickness of at least 5 µm.

16. Cutting tip or cutting tool according to claim 1, **characterised in that** the cover layer (17) has a columnar structure with a column width of 0.4 - 0.5 µm.

17. Cutting tip or cutting tool according to claim 1, **characterised in that** the entire layer structure is generated in the CVD process.

18. Cutting tip or cutting tool according to claim 1, **characterised in that** the cover layer (17) has compressive stresses in an outer zone.

19. Cutting tip or cutting tool according to claim 1, **characterised in that** the cover layer (17) is provided at least in sections with an outer layer (18), and that the cover layer (17) has zones, in which the outer layer has been subsequently removed by an abrasive process.

20. Cutting tip or cutting tool according to claim 1, **characterised in that** at least one of the Al₂O₃ layers is a κ-Al₂O₃ layer.

21. Cutting tip or cutting tool according to claim 1, **characterised in that** at least one of the Al₂O₃ layers is an α-Al₂O₃ layer.

22. Cutting tip or cutting tool according to claim 1, **characterised in that** the cover layer (17) has an inherent tensile stress, which is at least 50% lower than the inherent tensile stress of the base layer (3).

23. Cutting tip or cutting tool according to claim 1, **characterised in that** the outer Al₂O₃ layer (7) has an inherent tensile stress, which is at least 1/3 lower than the inherent tensile stress of the inner Al₂O₃ layer.

## Revendications

1. Plaque de coupe pour un outil de coupe, ou outil de coupe, qui porte un revêtement réducteur d'usure, constitué :
- d'une multicouche de base (2, 3), composée au moins de nitrures, de carbures, de carbonitrures et d'au moins un oxycarbonitrure, un nitrure de bore, un borocarbonitrure, un borocarboxynitrure ou un oxycarbonitrure de métaux du 4^{ème} et/ou 5^{ème} et/ou 6^{ème} sous-groupe, contenant de l'aluminium, ou une combinaison de ces composés,
- d'une multicouche (4) d'Al₂O₃, composée de couches d'Al₂O₃ (5, 6, 7) et de couches intermédiaires (8, 9) contenant chacune au moins une couche (11, 12) de TiCN et au moins une couche (11a, 12a) de TiCNO, qui sont disposées entre les couches d'Al₂O₃ (5, 6, 7),
- d'une couche de couverture (17) comprenant au moins deux couches et constituée de nitrures, de carboxonitrures ou de nitrures de Ti, Zr ou Hf ou d'une combinaison de ces couches, son épaisseur dépassant 3 microns.

2. Plaque de coupe ou outil de coupe selon la revendication 1, **caractérisée en ce que** les couches (5, 6, 7) d'Al₂O₃ ont une épaisseur de 0,5 à 4 microns, de préférence 1 à 3 microns.

3. Plaque de coupe ou outil de coupe selon la revendication 1, **caractérisée en ce que** la couche de couverture (17) a une épaisseur qui est 1,5 à 2 fois celle d'une couche (5, 6, 7) d'Al₂O₃.

4. Plaque de coupe ou outil de coupe selon la revendication 1, **caractérisée en ce que** les couches (5, 6,7) d'Al₂O₃ ont une épaisseur de 2 microns.

5. Plaque de coupe ou outil de coupe selon la revendication 1, **caractérisée en ce que** les couches (11, 12) de TiCN dans les couches intermédiaires (8, 9) sont des couches polycristallines.

6. Plaque de coupe ou outil de coupe selon la revendication 1, **caractérisée en ce que** les couches intermédiaires (8, 9) présentent, en plus de la couche (11, 12) de TiCN au nombre d'une au moins et de la couche (11a, 12a) de TiCNO au nombre d'une au moins, au moins une couche intermédiaire d'ancrage (13, 14) de TiAlCNO qui contient au plus 4 % d'aluminium.

7. Plaque de coupe ou outil de coupe selon la revendication 1, **caractérisée en ce que** la couche intermédiaire (8, 9) a une épaisseur de 0,2 à 2 microns, de préférence 0,5 à 1,5 microns.

8. Plaque de coupe ou outil de coupe selon la revendication 1, **caractérisée en ce que** la couche intermédiaire (8, 9) a une épaisseur d'un micron.

9. Plaque de coupe ou outil de coupe selon la revendication 6, **caractérisée en ce que** la couche intermédiaire d'ancrage (13, 14) en TiAlCNO a une épaisseur de 0,1 à 0,7 micron.

10. Plaque de coupe ou outil de coupe selon la revendication 1, **caractérisée en ce que** la multicouche (4) en Al₂O₃ est déposée sur une couche d'ancrage (15) en TiAlCNO contenant au plus 4 % d'aluminium.

11. Plaque de coupe ou outil de coupe selon la revendication 10, **caractérisée en ce que** la couche d'ancrage (15) en TiAlCNO a une épaisseur de 0,2 à 1 micron.

12. Plaque de coupe ou outil de coupe selon la revendication 11, **caractérisée en ce que** la couche d'ancrage (15) en TiAlCNO a une épaisseur de 0,5 micron.

13. Plaque de coupe ou outil de coupe selon la revendication 1, **caractérisée en ce qu'**au-dessous de la couche d'ancrage (15) en TiAlCNO, la couche de base (3) est constituée en partie d'une couche (3) en MT-TiCN, à fines colonnes dont chacune a une largeur de 0,1 à 0,5 micron.

14. Plaque de coupe ou outil de coupe selon la revendication 1, **caractérisée en ce que** la couche de base (3), en allant du substrat à la multicouche (4) en Al₂O₃, présente la constitution suivante :
1) une couche (2) MT-TiN
2) une couche (3 a) MT-TiCN
3) une couche (3b) HT - Ti (CₓN_{y}), (riche en azote), avec Y > 0,5
4) une couche (3c) HT - Ti (CₓN_{y}), (riche en carbone), avec X > 0,5
5) une couche (3d) HT - TiCNO
6) HT-TiAlCNO.

15. Plaque de coupe ou outil de coupe selon la revendication 1, **caractérisée en ce que** la couche de couverture (17) a une épaisseur d'au moins 5 microns.

16. Plaque de coupe ou outil de coupe selon la revendication 1, **caractérisée en ce que** la couche de couverture (17) est structurée en colonnes dont chacune a une largeur de 0,4 à 0,5 micron.

17. Plaque de coupe ou outil de coupe selon la revendication 1, **caractérisée en ce que** l'ensemble de la structure en couches est obtenue par le procédé CVD.

18. Plaque de coupe ou outil de coupe selon la revendication 1, **caractérisée en ce que** la couche de couverture (17) présente dans une zone externe des tensions de pression.

19. Plaque de coupe ou outil de coupe selon la revendication 1, **caractérisée en ce que** la couche de couverture (17) est dotée au moins localement d'une couche externe (18) et qu'elle présente des zones dans lesquelles cette couche externe est éliminée ultérieurement par un processus d'abrasion.

20. Plaque de coupe ou outil de coupe selon la revendication 1, **caractérisée en ce qu'**au moins une des couches d'Al₂O₃ est une couche κ - Al₂O₃.

21. Plaque de coupe ou outil de coupe selon la revendication 1, **caractérisée en ce qu'**au moins une des couches d'Al₂O₃ est une couche α-Al₂O₃.

22. Plaque de coupe ou outil de coupe selon la revendication 1, **caractérisée en ce que** la couche de couverture (18) présente une tension propre de traction, qui est au moins inférieure de moitié à la tension propre de traction de la couche de base (3).

23. Plaque de coupe ou outil de coupe selon la revendication 1, **caractérisée en ce que** la couche externe (7) en Al₂O₃ présente une tension propre de traction, qui est au moins inférieure d'un tiers à la tension propre de traction de la couche interne en Al₂O₃.
